# EUROPEAN PATENT APPLICATION

(11) **EP 4 156 156 A1**
(43) Date of publication of application: **29.03.2023**
(21) Application number: 21809064.5
(22) Date of filing: 28.04.2021
(51) Int. Cl.: G09F 9/33

(54) **LIGHT EMITTING MODULE, DISPLAY MODULE, DISPLAY SCREEN, AND DISPLAY**

(30) Priority: 22.05.2020 CN 202010439787
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN)
(74) Representative: Zacco GmbH
(86) International application number: PCT/CN2021/090579
(87) International publication number: WO 2021/233098

(57) **Abstract**

The present application relates to the technical field of optics, and discloses a light-emitting module (100), comprising: a light-emitting unit layer (110), comprising a plurality of light-emitting units (111); and a backlight isolation layer (120) arranged at a backlight surface (112) of the light-emitting unit layer (110). According to the light-emitting module (100), light emitted by the light-emitting units (111) is prevented from being transmitted in an undesired direction as far as possible by the backlight isolation layer (120) arranged at the backlight surface (112) of the light-emitting unit layer (110), thereby benefiting improvement of a display effect. The present application further discloses a display module (700), a display screen (800) and a display (900).

## Description

The present application claims priority to the Chinese Patent Application with an application number of 202010439787.7 and a title of *"Light-emitting Module, Display Module*, *Display Screen and Display*", filed to China National Intellectual Property Administration on May, 22nd, 2020, the disclosures of which are hereby incorporated by reference.

### TECHNICAL FIELD

The present application relates to the technical field of optics, and for example, relates to a light-emitting module, a display module, a display screen and a display.

### BACKGROUND

At present, light-emitting units are usually used to support display.

In a process of implementing embodiments of the present disclosure, at least the following problems are found in related technologies:
Part of light emitted by the light-emitting units will be transmitted in an undesired direction; and the light transmitted in the undesired direction will influence a display effect.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a light-emitting module, a display module, a display screen and a display, to solve a technical problem that part of light emitted by light-emitting units will be transmitted in an undesired direction to influence a display effect.

The light-emitting module provided by embodiments of the present disclosure comprises:
a light-emitting unit layer, comprising a plurality of light-emitting units;
a backlight isolation layer, arranged at a backlight surface of the light-emitting unit layer.

In some embodiments, the backlight isolation layer may comprise at least one of a backlight Distributed Bragg Reflector (DBR) reflection layer, a backlight metal reflection layer and a backlight absorption layer.

In some embodiments, the backlight isolation layer may comprise at least one layer of backlight DBR reflection layers. Optionally, the backlight isolation layer may comprise at least one layer of backlight metal reflection layers. Optionally, the backlight isolation layer may comprise at least one layer of backlight absorption layers. Optionally, the backlight isolation layer may comprise at least one layer of backlight DBR reflection layers and at least one layer of backlight metal reflection layers. Optionally, the backlight isolation layer may comprise at least one layer of backlight DBR reflection layers and at least one layer of backlight absorption layers. Optionally, the backlight isolation layer may comprise at least one layer of backlight metal reflection layers and at least one layer of backlight absorption layers. Optionally, the backlight isolation layer may comprise at least one layer of backlight DBR reflection layers, at least one layer of backlight metal reflection layers and at least one layer of backlight absorption layers.

In some embodiments, the backlight isolation layer may be provided with a conductive hole for supporting the light-emitting unit layer to realize electrical connection.

In some embodiments, the conductive hole may be filled with a conductive material; the backlight isolation layer may comprise at least one of at least one layer of backlight DBR reflection layers and at least one layer of backlight absorption layers; and at least one of the at least one layer of backlight DBR reflection layers and the at least one layer of backlight absorption layers may be in direct contact with the conductive material.

In some embodiments, the conductive hole may be filled with the conductive material; and the backlight isolation layer may comprise at least one layer of backlight metal reflection layers; an insulation part may be arranged between the at least one layer of backlight metal reflection layers and the conductive material.

In some embodiments, part or all of regions in the insulation part may be provided with a light isolation material.

In some embodiments, one side, away from the light-emitting unit layer, of the backlight isolation layer may be provided with an electrical connection layer.

In some embodiments, the light-emitting unit layer may be electrically connected with the electrical connection layer through the conductive hole.

In some embodiments, the backlight isolation layer may comprise at least one layer of backlight metal reflection layers; and the at least one layer of backlight metal reflection layers may be provided with an insulation layer insulated from the electrical connection layer and the light-emitting unit layer.

In some embodiments, the insulation layer may comprise at least one of the following:
a first insulation layer arranged between the backlight metal reflection layer and the electrical connection layer;
a second insulation layer arranged between the backlight metal reflection layer and the light-emitting unit layer.

In some embodiments, part or all of regions of at least one of the first insulation layer and the second insulation layer may be provided with a light isolation material.

In some embodiments, the backlight isolation layer may be directly arranged at the backlight surface of the light-emitting unit layer.

In some embodiments, the backlight isolation layer may be attached to the backlight surface of the light-emitting unit layer.

In some embodiments, the backlight isolation layer may be arranged at part or all of regions in the backlight surface of the light-emitting unit layer.

In some embodiments, the backlight isolation layer may be arranged at a light-transmissive region of the backlight surface of the light-emitting unit layer.

In some embodiments, the plurality of light-emitting units may comprise:
at least one of a light-emitting diode (LED), a Mini LED and a Micro LED.

The display module provided by embodiments of the present disclosure comprises the light-emitting module.

The display screen provided by embodiments of the present disclosure comprises the display module.

The display provided by embodiments of the present disclosure comprises the display screen.

The light-emitting module, the display module, the display screen and the display provided by embodiments of the present disclosure may achieve the following technical effects:
Light emitted by the light-emitting units is prevented from being transmitted in an undesired direction as far as possible by the backlight isolation layer arranged at the backlight surface of the light-emitting unit layer, thereby benefiting improvement of a display effect.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, wherein:
Fig. 1 is a structural schematic diagram of a light-emitting module provided by embodiments of the present disclosure;
Figs. 2A, 2B, 2C, 2D, 2E, 2F and 2G are structural schematic diagrams of a backlight isolation layer provided by embodiments of the present disclosure;
Fig. 3 is another structural schematic diagram of the backlight isolation layer provided by embodiments of the present disclosure;
Figs. 4A, 4B and 4C are other structural schematic diagrams of the backlight isolation layer provided by embodiments of the present disclosure;
Fig. 5 is another structural schematic diagram of the backlight isolation layer provided by embodiments of the present disclosure;
Figs. 6A, 6B, 6C and 6D are structural schematic diagrams of an insulation part provided by embodiments of the present disclosure;
Fig. 7 is another structural schematic diagram of the light-emitting module provided by embodiments of the present disclosure;
Fig. 8 is another structural schematic diagram of the light-emitting module provided by embodiments of the present disclosure;
Fig. 9 is another structural schematic diagram of the light-emitting module provided by embodiments of the present disclosure;
Fig. 10 is a structural schematic diagram of an insulation layer provided by embodiments of the present disclosure;
Figs. 11A, 11B, 11C, 11D, 11E, 11F, 11G and 11H are other structural schematic diagrams of the insulation layer provided by embodiments of the present disclosure;
Figs. 12 A, 12B and 12C are other structural schematic diagrams of the light-emitting module provided by embodiments of the present disclosure;
Figs. 13A, 13B and 13C are other structural schematic diagrams of the light-emitting module provided by embodiments of the present disclosure;
Fig. 14 is a structural schematic diagram of a display module provided by embodiments of the present disclosure;
Fig. 15 is a structural schematic diagram of a display screen provided by embodiments of the present disclosure; and
Fig. 16 is a structural schematic diagram of a display provided by embodiments of the present disclosure.

### Reference numerals:

100: light-emitting module; 110: light-emitting unit layer; 111: light-emitting unit; 112: backlight surface; 1121: light-transmissive region; 120: backlight isolation layer; 1201: layer structure; 121: backlight DBR reflection layer; 122: backlight metal reflection layer; 123: backlight absorption layer; 124: conductive hole; 125: conductive material; 126: insulation part; 127: light isolation material; 128: insulation layer; 1281: first insulation layer; 1282: second insulation layer; 130: electrical connection layer; 700: display module; 800: display screen; 900: display; and EG: edge.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

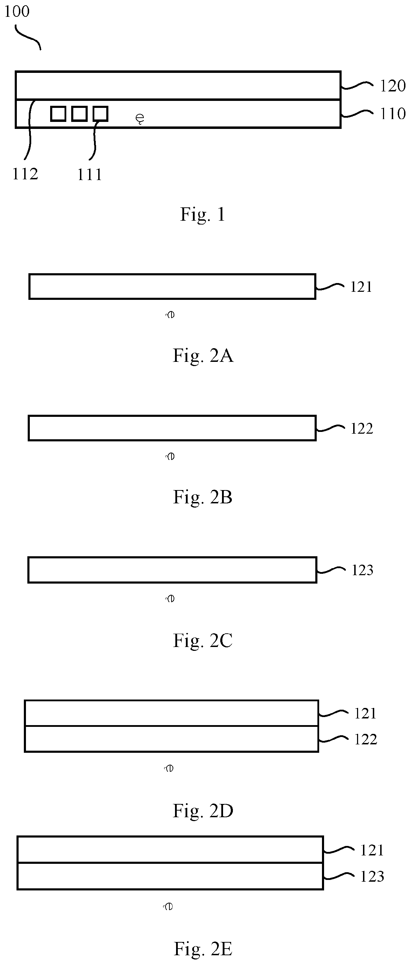

Referring to Fig. 1, embodiments of the present disclosure provide a light-emitting module 100, comprising:
a light-emitting unit layer 110, comprising a plurality of light-emitting units 111;
a backlight isolation layer 120 arranged at a backlight surface 112 of the light-emitting unit layer 110.

In this way, light emitted by the light-emitting units 111 may be prevented from being transmitted in an undesired direction (e.g., the light emitted by the light-emitting units 111 passes through the backlight surface 112 of the light-emitting unit layer 110) as far as possible, thereby benefiting improvement of display effect.

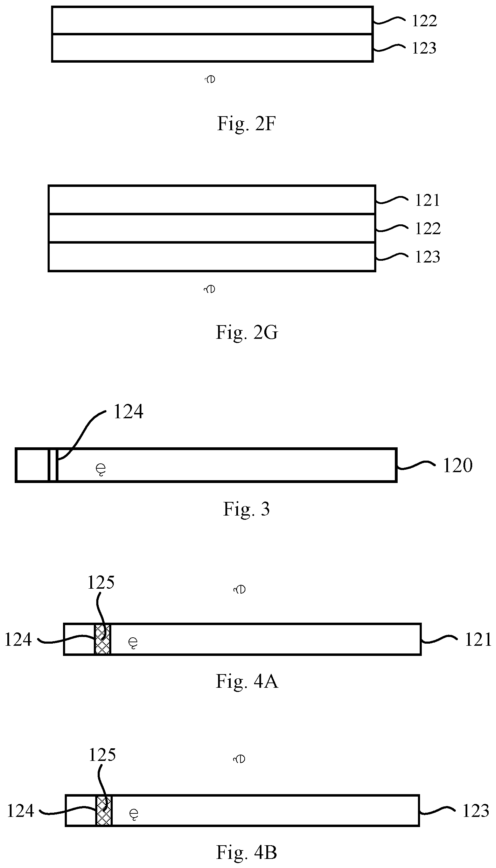

Referring to Figs. 2A, 2B, 2C, 2D, 2E, 2F and 2G, in some embodiments, the backlight isolation layer 120 may comprise at least one of a backlight DBR reflection layer 121, a backlight metal reflection layer 122 and a backlight absorption layer 123.

In some embodiments, the backlight DBR reflection layer 121 may comprise a structure and material capable of realizing light reflection. Optionally, the structure and material of the backlight DBR reflection layer 121 may be determined according to actual conditions such as process requirements, as long as the light emitted by the light-emitting unit layer 110 may be reflected.

In some embodiments, the backlight metal reflection layer 122 may comprise a structure and material capable of realizing light reflection, such as at least one of silver, aluminum and other metals. Optionally, the material included in the backlight metal reflection layer 122 may be determined according to actual conditions such as process requirements, as long as the light emitted by the light-emitting unit layer 110 may be reflected.

In some embodiments, the backlight absorption layer 123 may comprise a structure and material capable of realizing light absorption, such as a resin composition. Optionally, the material for realizing light absorption may also comprise a black matrix (BM). Optionally, the structure and material of the backlight absorption layer 123 may be determined according to actual conditions such as process requirements, as long as the light emitted by the light-emitting unit layer 110 may be absorbed.

In some embodiments, the backlight isolation layer 120 may comprise other structures and materials besides at least one of the backlight DBR reflection layer 121, the backlight metal reflection layer 122 and the backlight absorption layer 123. Optionally, the backlight isolation layer 120 may not comprise any one of the backlight DBR reflection layer 121, the backlight metal reflection layer 122 and the backlight absorption layer 123, but may comprise other structures and materials. Optionally, the structure and material of the backlight isolation layer 120 may be determined according to actual conditions such as process requirements; and regardless of the structure and material of the backlight isolation layer 120, as long as the backlight isolation layer 120 is capable of isolating the light emitted by the light-emitting unit layer 110, the light emitted by the light-emitting unit 111 may be prevented from being transmitted in an undesired direction as far as possible.

In some embodiments, the backlight isolation layer 120 may completely or proportionally isolate the light emitted by the light-emitting unit layer 110 in a mode of reflection, absorption or the like, for example, isolating the light emitted by the light-emitting unit layer 110 by 100%, 90%, 80% or other proportions. Optionally, the proportion of isolating the light emitted by the light-emitting unit layer 110 may be determined according to actual conditions such as process requirements.

In some embodiments, as shown in Fig. 2A, the backlight isolation layer 120 may comprise at least one layer of backlight DBR reflection layers 121.

In some embodiments, as shown in Fig. 2B, the backlight isolation layer 120 may comprise at least one layer of backlight metal reflection layers 122, such as one, two, three or more layers of backlight metal reflection layers 122.

In some embodiments, as shown in Fig. 2C, the backlight isolation layer 120 may comprise at least one layer of backlight absorption layers 123, such as one, two, three or more layers of backlight absorption layers 123.

In some embodiments, as shown in Fig. 2D, the backlight isolation layer 120 may comprise at least one layer of backlight DBR reflection layers 121 and at least one layer of backlight metal reflection layers 122, such as one, two, three or more layers of backlight DBR reflection layers 121 and one, two, three or more layers of backlight metal reflection layers 122. Optionally, a layer relationship of various layers in at least one layer of backlight DBR reflection layers 121 and at least one layer of backlight metal reflection layers 122 may be determined according to actual conditions such as process requirements; for example, all the backlight DBR reflection layers 121 in at least one layer of backlight DBR reflection layers 121 are arranged relatively intensively, and all the backlight metal reflection layers 122 in at least one layer of backlight metal reflection layers 122 are arranged relatively intensively; or, the backlight DBR reflection layers 121 and the backlight metal reflection layers 122 are overlapped.

In some embodiments, as shown in Fig. 2E, the backlight isolation layer 120 may comprise at least one layer of backlight DBR reflection layers 121 and at least one layer of backlight absorption layers 123, such as one, two, three or more layers of backlight DBR reflection layers 121 and one, two, three or more layers of backlight absorption layers 123. Optionally, a layer relationship of various layers in at least one layer of backlight DBR reflection layers 121 and at least one layer of backlight absorption layers 123 may be determined according to actual conditions such as process requirements; for example, all the backlight DBR reflection layers 121 in at least one layer of backlight DBR reflection layers 121 are arranged relatively intensively, and all the backlight absorption layers 123 in at least one layer of backlight absorption layers 123 are arranged relatively intensively; or, the backlight DBR reflection layers 121 and the backlight absorption layers 123 are overlapped.

In some embodiments, as shown in Fig. 2F, the backlight isolation layer 120 may comprise at least one layer of backlight metal reflection layers 122 and at least one layer of backlight absorption layers 123, such as one, two, three or more layers of backlight metal reflection layers 122 and one, two, three or more layers of backlight absorption layers 123. Optionally, a layer relationship of various layers in at least one layer of backlight metal reflection layers 122 and at least one layer of backlight absorption layers 123 may be determined according to actual conditions such as process requirements; for example, all the backlight metal reflection layers 122 in at least one layer of backlight metal reflection layers 122 are arranged relatively intensively, and all the backlight absorption layers 123 in at least one layer of backlight absorption layers 123 are arranged relatively intensively; or, the backlight metal reflection layers 122 and the backlight absorption layers 123 are overlapped.

In some embodiments, as shown in Fig. 2G, the backlight isolation layer 120 may comprise at least one layer of backlight DBR reflection layers 121, at least one layer of backlight metal reflection layers 122 and at least one layer of backlight absorption layers 123, such as one, two, three or more layers of backlight DBR reflection layers 121, one, two, three or more layers of backlight metal reflection layers 122 and one, two, three or more layers of backlight absorption layers 123. Optionally, a layer relationship of various layers in at least one layer of backlight DBR reflection layers 121, at least one layer of backlight metal reflection layers 122 and at least one layer of backlight absorption layers 123 may be determined according to actual conditions such as process requirements; for example, all the backlight DBR reflection layers 121 in at least one layer of backlight DBR reflection layers 121 are arranged relatively intensively, all the backlight metal reflection layers 122 in at least one layer of backlight metal reflection layers 122 are arranged relatively intensively, and all the backlight absorption layers 123 in at least one layer of backlight absorption layers 123 are arranged relatively intensively; or, at least two of the backlight DBR reflection layers 121, the backlight metal reflection layers 122 and the backlight absorption layers 123 are overlapped.

Referring to Fig. 3, in some embodiments, the backlight isolation layer 120 may be provided with a conductive hole 124 for supporting the light-emitting unit layer 110 to realize electrical connection. Optionally, the number, arrangement position and the like of the conductive holes 124 may be determined according to actual conditions such as process requirements; for example, a plurality of conductive holes 124 may be provided; and optionally, part or all of the plurality of conductive holes 124 may be conductive through holes.

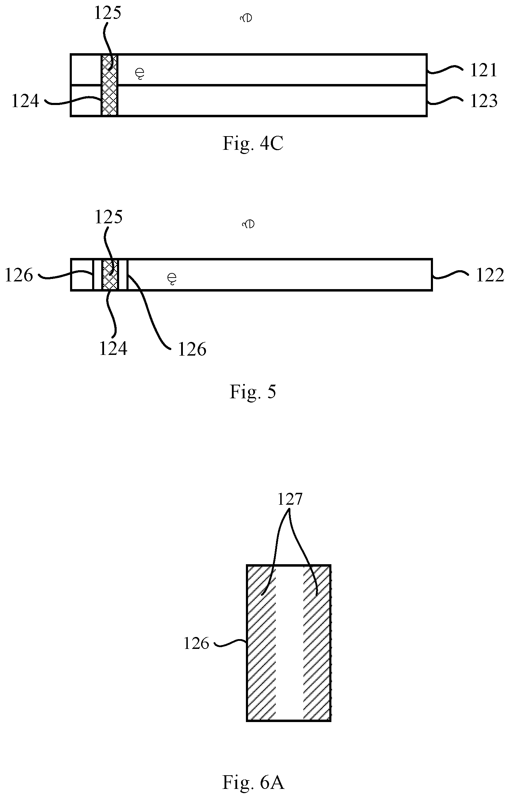

Referring to Figs. 4A, 4B and 4C, in some embodiments, the conductive holes 124 may be filled with a conductive material 125; the backlight isolation layer 120 may comprise at least one of at least one layer of backlight DBR reflection layers 121 and at least one layer of backlight absorption layers 123; and at least one of the at least one layer of backlight DBR reflection layers 121 and the at least one layer of backlight absorption layers 123 may be in direct contact with the conductive material 125.

In some embodiments, as shown in Fig. 4A, the conductive hole 124 may be filled with a conductive material 125; and the backlight isolation layer 120 may comprise at least one layer of backlight DBR reflection layers 121. Optionally, a plurality of conductive holes 124 may be provided. Optionally, part or all of the plurality of conductive holes 124 may be conductive through holes, which are capable of penetrating through part or all of all the backlight DBR reflection layers 121 in at least one layer of backlight DBR reflection layers 121. Optionally, the number, arrangement position and the like of the conductive holes 124 may be determined according to actual conditions such as process requirements.

In some embodiments, as shown in Fig. 4B, the conductive hole 124 may be filled with a conductive material 125; and the backlight isolation layer 120 may comprise at least one layer of backlight absorption layers 123. Optionally, a plurality of conductive holes 124 may be provided. Optionally, part or all of the plurality of conductive holes 124 may be conductive through holes, which are capable of penetrating through part or all of all the backlight absorption layers 123 in at least one layer of backlight absorption layers 123. Optionally, the number, arrangement position and the like of the conductive holes 124 may be determined according to actual conditions such as process requirements.

In some embodiments, as shown in Fig. 4C, the conductive hole 124 may be filled with a conductive material 125; and the backlight isolation layer 120 may comprise at least one layer of backlight DBR reflection layers 121 and at least one layer of backlight absorption layers 123. Optionally, a plurality of conductive holes 124 may be provided. Optionally, part or all of the plurality of conductive holes 124 may be conductive through holes, which are capable of penetrating through part or all of all the backlight DBR reflection layers 121 and backlight absorption layers 123 in at least one layer of backlight DBR reflection layers 121 and at least one layer of backlight absorption layers 123. Optionally, the number, arrangement position and the like of the conductive holes 124 may be determined according to actual conditions such as process requirements.

Referring to Fig. 5, in some embodiments, the conductive hole 124 may be filled with the conductive material 125; and the backlight isolation layer 120 may comprise at least one layer of backlight metal reflection layers 122; and an insulation part 126 is arranged between the at least one layer of backlight metal reflection layers 122 and the conductive material 125. Optionally, a plurality of conductive holes 124 may be arranged in the backlight isolation layer 120; and part or all of the plurality of conductive holes 124 may be arranged as shown in Fig. 5.

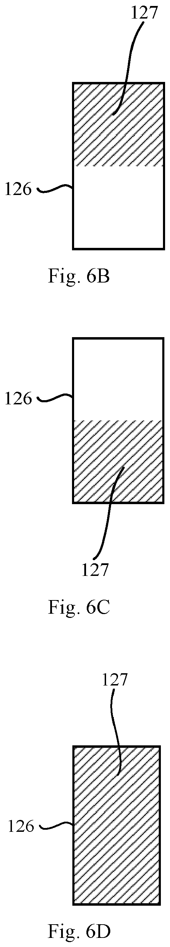

Referring to Figs. 6A, 6B, 6C and 6D, in some embodiments, part or all of regions in the insulation part 126 may be provided with a light isolation material 127.

In some embodiments, as shown in Fig. 6A, both sides of the insulation part 126 may be provided with the light isolation material 127.

In some embodiments, as shown in Fig. 6B, one side of the insulation part 126 may be provided with the light isolation material 127.

In some embodiments, as shown in Fig. 6C, the other side of the insulation part 126 opposite to the side provided with the light isolation material 127 in Fig. 6B may be provided with the light isolation material 127.

In some embodiments, as shown in Fig. 6D, all of regions in the insulation part 126 are provided with the light isolation material 127.

In some embodiments, the regions provided with the light isolation material 127 in the insulation part 126 may be determined according to actual conditions such as process requirements.

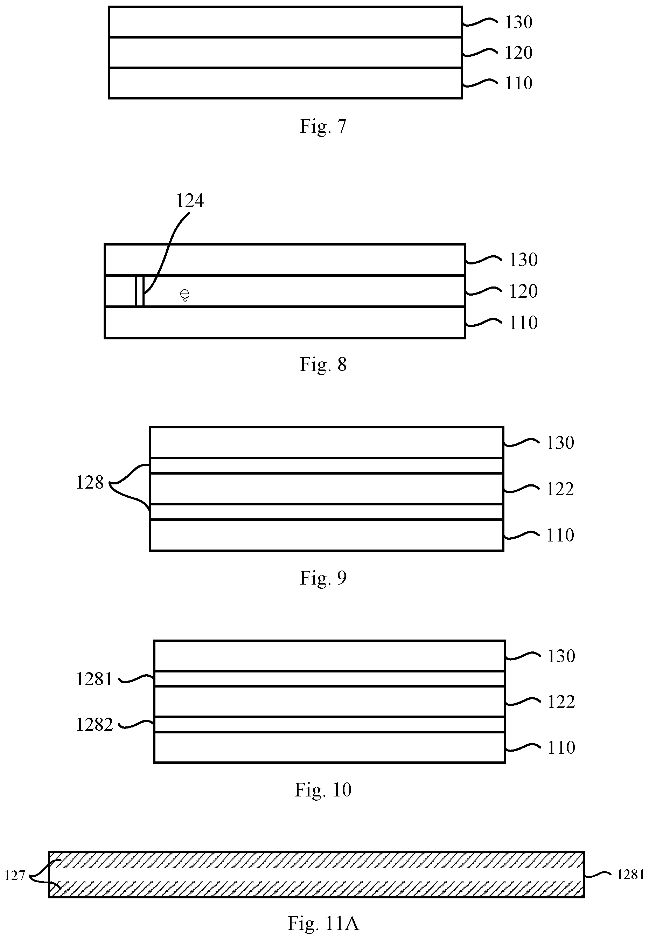

Referring to Fig. 7, in some embodiments, one side, away from the light-emitting unit layer 110, of the backlight isolation layer 120 may be provided with an electrical connection layer 130.

Referring to Fig. 8, in some embodiments, the light-emitting unit layer 110 may be electrically connected with the electrical connection layer 130 through the conductive hole 124. Optionally, the electrical connection between the light-emitting unit layer 110 and the electrical connection layer 130 may be realized in other modes than the conductive hole 124 according to actual conditions such as process requirements.

Referring to Fig. 9, in some embodiments, the backlight isolation layer 120 may comprise at least one layer of backlight metal reflection layers 122; and the at least one layer of backlight metal reflection layers 122 may be provided with an insulation layer 128 insulated from the electrical connection layer 130 and the light-emitting unit layer 110.

Referring to Fig. 10, in some embodiments, the insulation layer 128 may comprise at least one of the following:
a first insulation layer 1281 arranged between the backlight metal reflection layer 122 and the electrical connection layer 130;
a second insulation layer 1282 arranged between the backlight metal reflection layer 122 and the light-emitting unit layer 110.

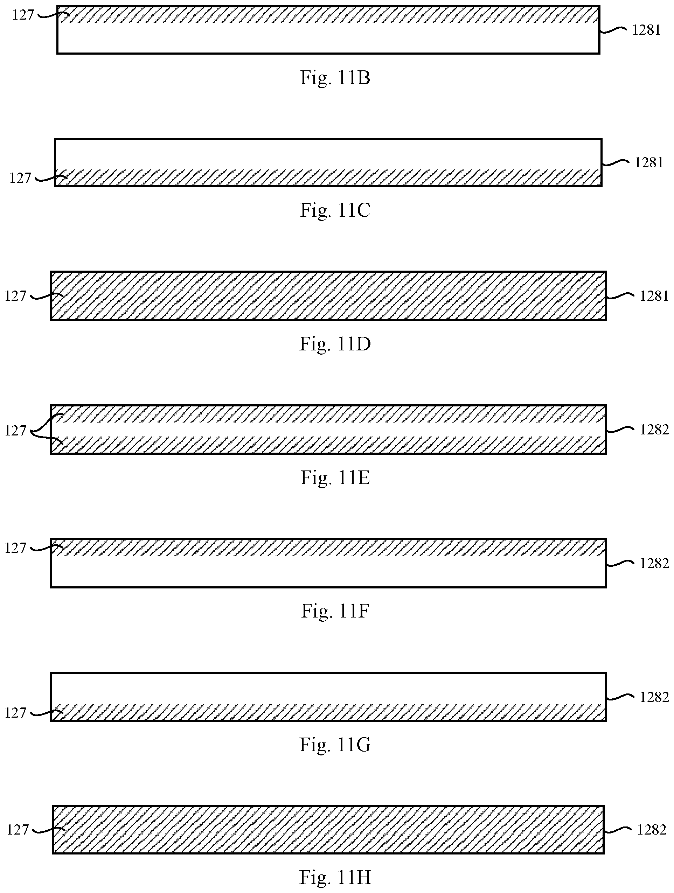

Referring to Figs. 11A, 11B, 11C, 11D, 11E, 11F, 11G and 11H, in some embodiments, part or all of regions of at least one of the first insulation layer 1281 and the second insulation layer 1282 may be provided with a light isolation material 127.

In some embodiments, as shown in Fig. 11A, both sides of the first insulation part 1281 are provided with the light isolation material 127.

In some embodiments, as shown in Fig. 11B, one side of the first insulation part 1281 is provided with the light isolation material 127.

In some embodiments, as shown in Fig. 11C, the other side of the first insulation part 1281, opposite to the side provided with the light isolation material 127, in Fig. 11B is provided with the light isolation material 127.

In some embodiments, as shown in Fig. 11D, all of regions in the first insulation part 1281 are provided with the light isolation material 127.

In some embodiments, as shown in Fig. 11E, both sides of the second insulation part 1282 are provided with the light isolation material 127.

In some embodiments, as shown in Fig. 11F, one side of the second insulation part 1282 is provided with the light isolation material 127.

In some embodiments, as shown in Fig. 11G, the other side of the second insulation part 1282, opposite to the side provided with the light isolation material 127, in Fig. 11F is provided with the light isolation material 127.

In some embodiments, as shown in Fig. 11H, all of regions in the second insulation part 1282 are provided with the light isolation material 127.

In some embodiments, the regions provided with the light isolation material 127 in the insulation part 128 (e.g., at least one of the first insulation layer 1281 and the second insulation layer 1282) may be determined according to actual conditions such as process requirements.

Referring to Fig. 1, in some embodiments, the backlight isolation layer 120 may be directly arranged at the backlight surface 112 of the light-emitting unit layer 110. Optionally, other devices or structures may not exist between the backlight isolation layer 120 and the backlight surface 112 of the light-emitting unit layer 110. Optionally, other devices or structures may be arranged in part or all of regions between the backlight isolation layer 120 and the backlight surface 112 of the light-emitting unit layer 110 according to actual conditions such as process requirements.

In some embodiments, the backlight isolation layer 120 may be attached to the backlight surface 112 of the light-emitting unit layer 110. Optionally, part or whole of the backlight isolation layer 120 may be attached to the backlight surface 112 of the light-emitting unit layer 110 according to actual conditions such as process requirements. Optionally, when part of the backlight isolation layer 120 is attached to the backlight surface 112 of the light-emitting unit layer 110, a certain distance may exist between a part of the backlight isolation layer 120 not attached to the backlight surface 112 of the light-emitting unit layer 110 and the backlight surface 112 of the light-emitting unit layer 110. Optionally, the distance may be set according to actual conditions such as process requirements.

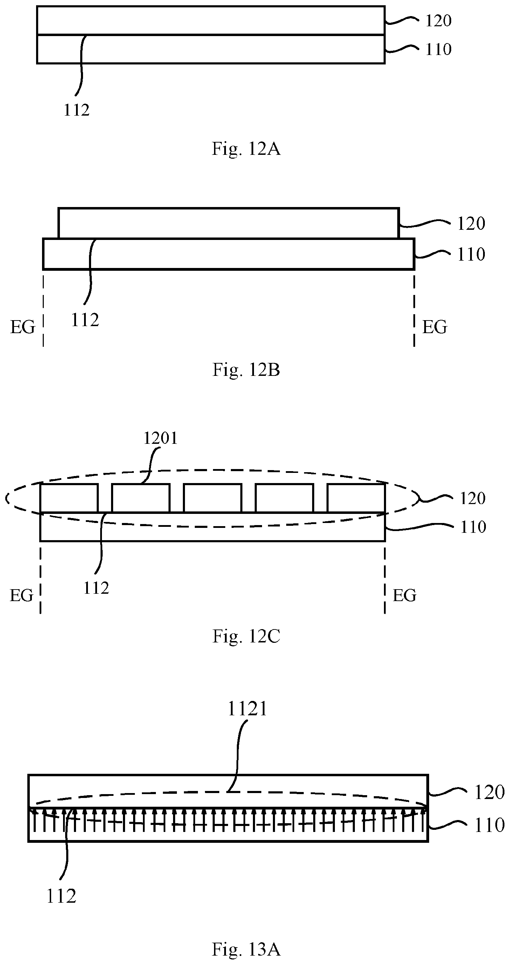

Referring to Figs. 12A, 12B and 12C, in some embodiments, the backlight isolation layer 120 may be arranged at part or all of regions in the backlight surface 112 of the light-emitting unit layer 110.

In some embodiments, as shown in Fig. 12A, the backlight isolation layer 120 is arranged at all of the regions in the backlight surface 112 of the light-emitting unit layer 110.

In some embodiments, as shown in Fig. 12B, the backlight isolation layer 120 is arranged at part of the regions in the backlight surface 112 of the light-emitting unit layer 110; and the part of regions may be a continuous region. Optionally, the continuous region may comprise at least one edge EG of the backlight surface 112 of the light-emitting unit layer 110, or may not comprise any edge EG of the backlight surface 112 of the light-emitting unit layer 110.

In some embodiments, as shown in Fig. 12C, the backlight isolation layer 120 (the backlight isolation layer 120 is surrounded by a dotted line for convenience of identification) is arranged at part of the regions in the backlight surface 112 of the light-emitting unit layer 110; and the part of the regions may be a discontinuous region. In this case, the backlight isolation layer 120 may be composed of more than one discontinuous layer structure 1201. Optionally, at least two discontinuous regions may be provided, wherein at least one discontinuous region may comprise at least one edge EG of the backlight surface 112 of the light-emitting unit layer 110 or may not comprise any edge EG of the backlight surface 112 of the light-emitting unit layer 110. Optionally, the positions and number of discontinuous regions in the backlight surface 112 of the light-emitting unit layer 110 for arrangement of the backlight isolation layer 120 may be determined according to actual conditions such as process requirements, so as to determine the positions and number of discontinuous layer structures 1201 constituting the backlight isolation layer 120.

In some embodiments, the backlight isolation layer 120 may be arranged at part or all of the regions in the backlight surface 112 of the light-emitting unit layer 110 according to actual conditions such as process requirements, as long as the backlight isolation layer 120 is capable of isolating the light emitted by the light-emitting unit layer 110 to prevent the light emitted by the light-emitting unit 111 from being transmitted in an undesired direction as far as possible.

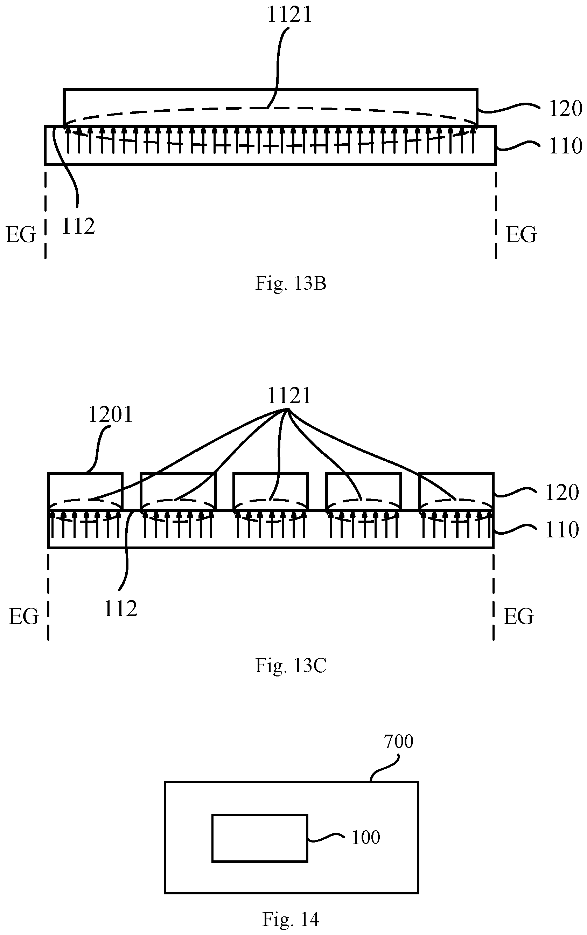

Referring to Figs. 13A, 13B and 13C, in some embodiments, the backlight isolation layer 120 may be arranged at a light-transmissive region 1121 of the backlight surface 112 of the light-emitting unit layer 110. In some embodiments, as shown in Figs. 13A, 13B and 13C, arrow graphics exemplarily show a direction of a part of light from the light-emitting unit layer 110 to the backlight isolation layer 120. Optionally, for the convenience of identification, the light-transmissive region 1121 is surrounded by a dotted line.

In some embodiments, as shown in Fig. 13A, the light-transmissive region 1121 of the backlight surface 112 of the light-emitting unit layer 110 comprises all of the regions in the backlight surface 112 of the light-emitting unit layer 110. In this case, the backlight isolation layer 120 may be arranged at all of the regions in the backlight surface 112 of the light-emitting unit layer 110, so that the backlight isolation layer 120 may be arranged at the light-transmissive region 1121 of the backlight surface 112 of the light-emitting unit layer 110.

In some embodiments, as shown in Fig. 13B, the light-transmissive region 1121 of the backlight surface 112 of the light-emitting unit layer 110 comprises part of the regions in the backlight surface 112 of the light-emitting unit layer 110; and the part of the regions may be a continuous region. In this case, the backlight isolation layer 120 may be arranged at part of the regions (e.g., the continuous region) in the backlight surface 112 of the light-emitting unit layer 110, so that the backlight isolation layer 120 may be arranged at the light-transmissive region 1121 of the backlight surface 112 of the light-emitting unit layer 110. Optionally, the continuous region may comprise at least one edge EG of the backlight surface 112 of the light-emitting unit layer 110, or may not comprise any edge EG of the backlight surface 112 of the light-emitting unit layer 110.

In some embodiments, as shown in Fig. 13C, the light-transmissive region 1121 of the backlight surface 112 of the light-emitting unit layer 110 comprises part of the regions in the backlight surface 112 of the light-emitting unit layer 110; and the part of the regions may be a discontinuous region. In this case, the backlight isolation layer 120 may be arranged at part of the regions (e.g., the discontinuous region) in the backlight surface 112 of the light-emitting unit layer 110, so that the backlight isolation layer 120 may be arranged at the light-transmissive region 1121 of the backlight surface 112 of the light-emitting unit layer 110. Correspondingly, the backlight isolation layer 120 may be composed of more than one discontinuous layer structure 1201. Optionally, at least two discontinuous regions may be provided, wherein at least one discontinuous region may comprise at least one edge EG of the backlight surface 112 of the light-emitting unit layer 110 or may not comprise any edge EG of the backlight surface 112 of the light-emitting unit layer 110. Optionally, the positions and number of discontinuous regions in the backlight surface 112 of the light-emitting unit layer 110 for arrangement of the backlight isolation layer 120 may be determined according to actual light-transmissive conditions such as process requirements, so as to determine the positions and number of discontinuous layer structures 1201 constituting the backlight isolation layer 120.

In some embodiments, the light-transmissive region 1121 of the backlight surface 112 of the light-emitting unit layer 110 may be determined according to actual light-transmissive conditions such as process requirements; and accordingly, it is considered that the backlight isolation layer 120 is arranged at the light-transmissive region 1121 of the backlight surface 112 of the light-emitting unit layer 110. Optionally, the light-transmissive region 1121 may comprise part or all of the regions in the backlight surface 112 of the light-emitting unit layer 110, and may be presented in a form of continuous region or discontinuous region; and the corresponding position, quantity and the like may be determined according to the actual light-transmissive conditions such as process requirements, as long as the backlight isolation layer 120 is capable of isolating the light emitted by the light-emitting unit layer 110 to prevent the light emitted by the light-emitting unit 111 from being transmitted in an undesired direction as far as possible.

In some embodiments, the plurality of light-emitting units 111 may comprise at least one of LED, Mini LED and Micro LED. Optionally, the plurality of light-emitting units 111 may comprise at least one LED. Optionally, the plurality of light-emitting units 111 may comprise at least one Mini LED. Optionally, the plurality of light-emitting units 111 may comprise at least one Mini LED. Optionally, the plurality of light-emitting units 111 may comprise at least one LED and at least one Mini LED. Optionally, the plurality of light-emitting units 111 may comprise at least one LED and at least one Micro LED. Optionally, the plurality of light-emitting units 111 may comprise at least one Mini LED and at least one Micro LED. Optionally, the plurality of light-emitting units 111 may comprise at least one LED, at least one Mini LED and at least one Micro LED. Optionally, the plurality of light-emitting units 111 may comprise other light-emitting devices besides LED, Mini LED and Micro LED.

In some embodiments, types of devices of the light-emitting unit 111, such as LED, Mini LED, Micro LED or other light-emitting devices, may be determined according to actual conditions such as process requirements.

Referring to Fig. 14, a display module 700 provided by embodiments of the present disclosure comprises the light-emitting module 100. In some embodiments, the display module 700 may support 3D display.

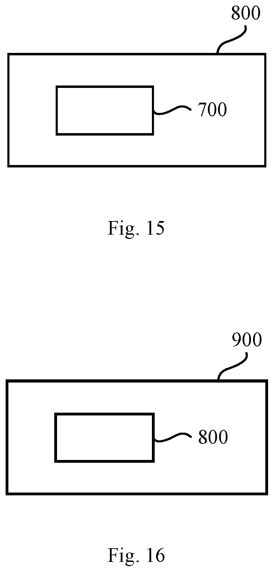

Referring to Fig. 15, a display screen 800 provided by embodiments of the present disclosure comprises the display module 700. In some embodiments, the display screen 800 may perform 3D display.

Referring to Fig. 16, a display 900 provided by embodiments of the present disclosure comprises the display screen 800. In some embodiments, the display 900 may perform 3D display. In some embodiments, the display 900 may further comprise other components for supporting normal operation of the display 900, such as at least one of a communication interface, a framework, a control circuit and the like.

According to the light-emitting module, the display module, the display screen and the display provided by embodiments of the present disclosure, light emitted by the light-emitting units is prevented from being transmitted in an undesired direction as far as possible by the backlight isolation layer arranged at the backlight surface of the light-emitting unit layer, thereby benefiting improvement of display effect and having a possibility of improving a light utilization rate.

The above description and drawings sufficiently illustrate the embodiments of the present disclosure to enable those skilled in the art to practice them. Other embodiments may comprise structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "comprise" and its variations "comprises" and/or "comprising", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

Those skilled in the art may recognize that the units and algorithm steps of each example described in conjunction with the embodiments disclosed herein can be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

In the drawings, considering clarity and description, the width, length and thickness of structures of components or layers can be exaggerated. When a structure of a component or layer is described to be "arranged" (or "installed" or "laid" or "fitted" or "coated" or similar illustration) "above" or "on" another component or layer, the structure of the component or layer may be directly "arranged" "above" or "on" another component or layer, or there may be a structure of an intermediate component or layer between the component or layer and another component or layer, or even a part of the component or layer is embedded in another component or layer.

## Claims

1. A light-emitting module, comprising:
a light-emitting unit layer, comprising a plurality of light-emitting units;
a backlight isolation layer, arranged at a backlight surface of the light-emitting unit layer.

2. The light-emitting module according to claim 1, wherein the backlight isolation layer comprises at least one of a backlight Distributed Bragg Reflector (DBR) reflection layer, a backlight metal reflection layer and a backlight absorption layer.

3. The light-emitting module according to claim 2, wherein
the backlight isolation layer comprises at least one layer of backlight DBR reflection layers; or
the backlight isolation layer comprises at least one layer of backlight metal reflection layers; or
the backlight isolation layer comprises at least one layer of backlight absorption layers; or
the backlight isolation layer comprises at least one layer of backlight DBR reflection layers and at least one layer of backlight metal reflection layers; or
the backlight isolation layer comprises at least one layer of backlight DBR reflection layers and at least one layer of backlight absorption layers; or
the backlight isolation layer comprises at least one layer of backlight metal reflection layers and at least one layer of backlight absorption layers; or
the backlight isolation layer comprises at least one layer of backlight DBR reflection layers, at least one layer of backlight metal reflection layers and at least one layer of backlight absorption layers.

4. The light-emitting module according to claim 2 or 3, wherein a conductive hole for supporting the light-emitting unit layer to realize electrical connection is arranged in the backlight isolation layer.

5. The light-emitting module according to claim 4, wherein the conductive hole is filled with a conductive material; the backlight isolation layer comprises at least one of at least one layer of backlight DBR reflection layers and at least one layer of backlight absorption layers; and at least one of at least one layer of the backlight DBR reflection layers and at least one layer of the backlight absorption layers is in direct contact with the conductive material.

6. The light-emitting module according to claim 4, wherein the conductive hole is filled with a conductive material; the backlight isolation layer comprises at least one layer of backlight metal reflection layers; and an insulation part is arranged between at least one layer of the backlight metal reflection layers and the conductive material.

7. The light-emitting module according to claim 6, wherein part or all of regions in the insulation part are provided with a light isolation material.

8. The light-emitting module according to any one of claims 4-7, wherein one side, away from the light-emitting unit layer, of the backlight isolation layer is provided with an electrical connection layer.

9. The light-emitting module according to claim 8, wherein the light-emitting unit layer is electrically connected with the electrical connection layer through the conductive hole.

10. The light-emitting module according to claim 8, wherein
the backlight isolation layer comprises at least one layer of backlight metal reflection layers; and at least one layer of the backlight metal reflection layers is provided with an insulation layer insulated from the electrical connection layer and the light-emitting unit layer.

11. The light-emitting module according to claim 10, wherein the insulation layer comprises at least one of the following:
a first insulation layer arranged between the backlight metal reflection layer and the electrical connection layer;
a second insulation layer arranged between the backlight metal reflection layer and the light-emitting unit layer.

12. The light-emitting module according to claim 11, wherein part or all of regions of at least one of the first insulation layer and the second insulation layer are provided with a light isolation material.

13. The light-emitting module according to any one of claims 1-12, wherein the backlight isolation layer is directly arranged at a backlight surface of the light-emitting unit layer.

14. The light-emitting module according to claim 13, wherein the backlight isolation layer is attached to a backlight surface of the light-emitting unit layer.

15. The light-emitting module according to any one of claims 1-14, wherein the backlight isolation layer is arranged at part or all of regions in a backlight surface of the light-emitting unit layer.

16. The light-emitting module according to claim 15, wherein the backlight isolation layer is arranged at a light-transmissive region of a backlight surface of the light-emitting unit layer.

17. The light-emitting module according to claim 1, wherein the plurality of light-emitting units comprise:
at least one of a light-emitting diode (LED), a Mini LED and a Micro LED.

18. A display module, comprising the light-emitting module of any one of claims 1-17.

19. A display screen, comprising the display module of claim 18.

20. A display, comprising the display screen of claim 19.
